(19) Europäisches Patentamt
European Patent Office
Office européen des brevets

(11) **EP 2 230 522 B1**

(12) **EUROPÄISCHE PATENTSCHRIFT**

(45) Veröffentlichungstag und Bekanntmachung des Hinweises auf die Patenterteilung:
**11.05.2011 Patentblatt 2011/19**

(51) Int Cl.:
*G01R 27/18* (2006.01)      *G01R 31/12* (2006.01)
*H02M 7/00* (2006.01)

(21) Anmeldenummer: **09155278.6**

(22) Anmeldetag: **16.03.2009**

(54) **Verfahren und Vorrichtung zur Isolationsüberwachung eines Netzes ohne Neutralleiter**

Method and device for insulation monitoring of a network without a neutral conductor

Procédé et dispositif de surveillance d'isolation d'un réseau isolé terre

(84) Benannte Vertragsstaaten:
**DE ES FR IT**

(43) Veröffentlichungstag der Anmeldung:
**22.09.2010 Patentblatt 2010/38**

(73) Patentinhaber: **SMA Solar Technology AG**
**34266 Niestetal (DE)**

(72) Erfinder: **Lehmann, Reinhard**
**34123 Kassel (DE)**

(74) Vertreter: **Rehberg Hüppe + Partner**
**Patentanwälte**
**Nikolausberger Weg 62**
**37073 Göttingen (DE)**

(56) Entgegenhaltungen:
**EP-A- 1 265 076      DE-A1- 10 125 910**
**JP-A- 9 285 015      US-A1- 2002 105 765**
**US-A1- 2009 046 492**

## Beschreibung

### TECHNISCHES GEBIET DER ERFINDUNG

Die Erfindung betrifft ein Verfahren zur Isolationsüberwachung eines IT-Netzes gegenüber Erde mit den Merkmalen des Oberbegriffs des unabhängigen Patentanspruchs 1 sowie auf eine entsprechende Vorrichtung zur Isolationsüberwachung eines IT-Netzes gegenüber Erde mit den Merkmalen des Oberbegriffs des unabhängigen Patentanspruchs 9.

Ein IT (französisch: Isolé Terre)-Netz weist keinen Null- oder Neutralleiter auf. Damit führt ein Isolationsfehler zwischen einem der Leiter und Erde zunächst nur zu einer Erdung dieses Leiters. Bei einem IT-Netz, wie es in den Oberbegriffen der unabhängigen Patentansprüche 1 und 9 definiert ist, ergeben sich jedoch im Fall eines Erdschlusses eines Leiters auf der Wechselstromseite hohe Ströme. Dies gilt insbesondere bei Wechselrichtern mit hochfrequenter Taktung. Diese hohen Ströme resultieren in eine Gefährdung von Personen und Anlagen, so dass bei ihrem Auftreten sofort abgeschaltet werden muss.

### STAND DER TECHNIK

Aus der DE 10 2006 022 686 A1 ist eine Messanordnung zur Ermittlung des Isolationswiderstands einer Anordnung mit einer Photovoltaikanlage bekannt, die über einen Wechselrichter an ein einphasiges Netz mit geerdetem Neutralleiter angeschlossen ist. Die bekannte Messanordnung zur Ermittlung des Isolationswiderstands gegenüber Erde kann daher nur bei deaktiviertem Wechselrichter arbeiten. Gemessen wird der Isolationswiderstand mit Hilfe von einseitig geerdeten Referenzwiderständen, die wechselweise mit den beiden von der Photovoltaikanlage kommenden Leitern auf der Gleichstromseite des Wechselrichters verbunden werden, wobei die zwischen den beiden Leitern und Erde abfallenden Spannungen gemessen werden. Alternativ können auch die Ströme gemessen werden, die bei wechselweiser Verbindung der beiden Leiter mit Erde fließen. Jede einzelne Messung eines Stroms oder einer Spannung dauert bei der bekannten Messanordnung mehrere Sekunden bis zu Minuten, da sich zunächst eine stabile Ladungsverteilung über allen gegenüber Erde wirksamen Kapazitäten einstellen muss.

Aus der EP 1 265 076 B1, die neben anderen Dokumenten als Stand der Technik in der Beschreibungseinleitung der DE 10 2006 022 686 A1 gewürdigt ist, ist eine Sicherheitsvorrichtung für die Überwachung einer Gleichspannungsbusisolation bekannt. Als Anwendungsmöglichkeit wird dabei auf eine Photovoltaikanlage verwiesen, die über einen Wechselrichter und einen Isolationstrafo an ein Wechselstromnetz angeschlossen ist. Durch den Isolationstrafo ist auch die Wechselstromseite des Transformators gegenüber Erde isoliert, so dass die Überwachung der Gleichspannungsbusisolation auch bei laufendem Wechselrichter erfolgen kann, da dieser nicht mit Erde verbindet. Damit sind die Merkmale der Oberbegriffe der unabhängigen Patentansprüche 1 und 9 erfüllt. Die Überwachung der Gleichspannungsbusisolation beruht auch hier auf der Messung von Spannungen, die von den Leitern auf der Gleichstromseite des Wechselrichters über einseitig geerdeten Referenzwiderständen abfallen.

Aus der EP 0 833 423 A2 ist eine weitere Isolationsüberwachung für ein IT-Netz auf der Basis von Spannungsabfällen über Referenzwiderständen bekannt, wobei hier keine Anwendung in Verbindung mit einer an einen Wechselrichter angeschlossenen Photovoltaikanlage beschrieben ist.

Als weitere Vorrichtung mit den Merkmalen des Oberbegriffs des unabhängigen Patentanspruchs 9, deren Anwendung in ein Verfahren mit den Merkmalen des Oberbegriffs des unabhängigen Patentanspruchs 1 resultiert, ist ein Produkt der Firma Dipl.-Ing. W. Bender GmbH & Co. KG mit der Produktbezeichnung IRDH 275 bekannt. Diese bekannte Vorrichtung legt an jeweils einen der Leiter auf der Gleichstromseite des Wechselrichters eine definierte Spannung gegenüber Erde an und misst den resultierenden Strom, der auch dann noch fließt, wenn sich eine stabile Ladungsverteilung über allen gegenüber Erde wirksamen Kapazitäten eingestellt hat. Dieser Strom ist ein direktes Maß für den Isolationswiderstand des jeweiligen Leiters gegenüber Erde. Diese Messung wird bei jedem der beiden Leiter auf der Gleichstromseite des Wechselrichters durchgeführt. Zusätzlich wird zwischen zwei aufeinander folgenden Messungen an demselben Leiter die Polarität gegenüber Erde umgekehrt, um das Messergebnis abzusichern. Aufgrund der Kapazitäten gegenüber Erde, die im Falle jeder neuen Messung umzuladen sind, bis sich ein stabiler Messwert einstellt, benötigt jede Messung mehrere Sekunden bis Minuten. Entsprechend kann auch mit dieser bekannten Vorrichtung und bei diesem bekannten Verfahren ein Isolationsfehler nur sehr langsam erkannt werden. Allerdings werden wie bei den zuvor beschriebenen Verfahren und Vorrichtungen auch kleine Isolationsfehler mit hohem Isolationswiderstand mit großer Genauigkeit erkannt. In der bekannten Anwendung der Vorrichtung der Firma Bender mit den Merkmalen des Oberbegriffs der unabhängigen Patentansprüche 1 und 7 werden diese Isolationsfehler des IT-Netzes auch auf der Wechselstromseite des Wechselrichters erfasst, da sich diese über den Wechselrichter bis auf die Gleichstromseite des Wechselrichters auswirken.

Sogenannte FI-Schalter oder auch Fehlerstromschutzschalter, nach ihrer englischsprachigen Bezeichnungen Residual Current Protective Device auch RCD genannt, trennen beim Überschreiten einer bestimmten Differenzstromstärke zwischen abfließendem und zurückfließendem Strom, die auf einen Stromabfluss nach Erde hinweist, einen überwachten Wechselstromkreis vom Netz. Für die Ermittlung der Differenzstromstärke werden die Leiter des überwachten Wechselstromkreises gemeinsam durch einen Ringkern geführt. Die resultierende Magnetisierung des Ringkerns ist eine Folge der vorzeichenrichtig addierten Summe der Ströme durch die Leiter. Bei einem Kurzschluss eines Leiters des Wechselstromkreises gegenüber Erde resultiert eine instationäre Stromdifferenz, die durch eine Induktionsspule um den Ringkern einfach erfasst und in ein Signal zum Abschalten des überwachten Stromkreises umgewandelt werden kann. Der Einsatz von Fehlerstromschutzschaltern zur Erdschlussüberwachung in einem IT-Netz gilt als grundsätzlich nicht möglich (siehe z. B. http://de.wikipedia.org/wiki/Niederspannungsnetz, dort den Text zu IT-System unter der Zwischenüberschrift Arten).

Aus der US 2002/105765 A1 sind ein Verfahren und eine Vorrichtung zum Erkennen von Isolationsfehlern einer Photovoltaikanlage gegenüber Erde bekannt. Hierzu wird ein Differenzstrom zwischen den Eingangsleitungen eines Wechselrichters, der die elektrische Energie von der Photovoltaikanlage in ein Wechselstromnetz einspeist, erfasst. Dieser Differenzstrom weist neben einem interessierenden Fehlerstrom im Falle eines Erdschlusses im Bereich der Photovoltaikanlage einen Ableitstromanteil auf, der aufgrund von endlichen Kapazitäten der Photovoltaikanlage gegenüber Erde in Folge von Potentialsprüngen der Eingangsleitungen gegenüber dem Erdbezug der Ausgangsleitungen des Wechselrichters mit der Schaltfrequenz des Wechselrichters auftritt. Diese Ableitstromanteile, die auf der Gleichstromseite des Wechselrichters über die Kapazitäten der Photovoltaikanlage auch ohne Auftreten eines Fehlers nach Erde abfließen, werden von dem Differenzstrom entfernt, um nur das eigentlich interessierende Fehlerstromsignal zu erhalten. Die US 2002/105765 A1 befasst sich nicht mit irgendwelchen Isolationsfehlern der Ausgangsleitungen des Wechselrichters auf dessen Wechselstromseite.

## AUFGABE DER ERFINDUNG

Der Erfindung liegt die Aufgabe zugrunde, ein Verfahren und eine Vorrichtung zur Isolationsüberwachung eines IT-Netzes mit den Merkmalen des Oberbegriffs des unabhängigen Patentanspruchs 1 bzw. des unabhängigen Patentanspruchs 9 aufzuzeigen, mit denen sowohl kleine Isolationswiderstandsänderungen auf beiden Seiten des Wechselrichters zuverlässig erkannt als auch besonders gefährliche Isolationsfehler auf der Wechselstromseite des Wechselrichters schnell identifiziert werden können.

## LÖSUNG

Die Aufgabe der Erfindung wird durch ein Verfahren mit den Merkmalen des unabhängigen Patentanspruchs 1 und eine Vorrichtung mit den Merkmalen des unabhängigen Patentanspruchs 9 gelöst. Bevorzugte Ausführungsformen des neuen Verfahrens und der neuen Vorrichtung sind in den abhängigen Patentansprüchen definiert.

## BESCHREIBUNG DER ERFINDUNG

Bei dem neuen Verfahren wird zusätzlich zu der Überwachung des Isolationswiderstands der Gleichstromseite ein Ableitstrom über den laufenden Wechselrichter nach Erde überwacht. Beide Überwachungen erfassen aufgrund des seine Gleichstromseite mit seiner Wechselstromseite galvanisch verbindenden Wechselrichters auch Kurzschlüsse auf der Wechselstromseite und im Wechselrichter gegenüber Erde. Dabei spricht die Messung des Ableitstroms auf derartige Kurzschlüsse sehr schnell an, so dass hieraus resultierenden Gefahren für Menschen und Anlagen mit der notwendigen Geschwindigkeit begegnet werden kann.

Überraschenderweise kann der Ableitstrom bei dem neuen Verfahren durch einfaches Überwachen der Differenz des Stroms durch die beiden Leiter der Gleichstromseite zu dem Wechselrichter überwacht werden, indem das durch die beiden Leiter gemeinsam induzierte Magnetfeld mit einer Induktionsspule erfasst wird. Durch den Wechselrichter, der die Leiter der Gleichstromseite taktweise mit dem kurzgeschlossenen Leiter der Wechselstromseite verbindet, resultiert aus dem Kurzschluss auf der Wechselstromseite gegen Erde eine Modulation der Differenz des Stroms durch die beiden Leiter, die ein starkes Signal in der Induktionsspule hervorruft. Mit diesem Signal kann der Wechselrichter ausgeschaltet oder die Wechselstromseite des Wechselrichters auf andere Weise von dem Photovoltaikpaneel getrennt werden.

Der Isolationswiderstand kann bei dem neuen Verfahren durch jedes Verfahren erfasst werden, das in einem der Dokumente beschrieben ist, welche in der Beschreibungseinleitung zitiert sind. Besonders bevorzugt ist es jedoch, wenn der Isolationswiderstand durch Vergleich mit Referenzwiderständen überwacht wird. Dabei werden auch kleinere Fehler beim Isolationswiderstand entdeckt. Die Dauer jeder einzelnen Messung ist aber mit einigen Sekunden bis Minuten zu lang, um gefährliche Kurzschlüsse gegenüber Erde auf der Wechselstromseite des Wechselrichters schnell zu erkennen. Zu diesem Zweck wird bei dem neuen Verfahren der Ableitstrom überwacht.

Besonders bevorzugt ist es bei dem neuen Verfahren, wenn die Isolationswiderstände der beiden Leiter der Gleichstromseite nach Erde einzeln überwacht werden. So können auch Isolationsfehler der einzelnen Leiter auf der Gleichstromseite von Isolationsfehlern auf der Wechselstromseite unterschieden werden, die sich auf den Isolationswiderstand beider Leiter auf der Gleichstromseite auswirken.

Wie bei IT-Netzen nach den Oberbegriffen der unabhängigen Patentansprüche 1 und 9 üblich, ist es auch bei dem neuen Verfahren bevorzugt, wenn zwischen die beiden Leiter der Gleichstromseite zwei Kapazitäten in Reihe geschaltet sind, deren Mittelpunkt geerdet ist. Auf diese Weise wird ein EMV-Filter ausgebildet und ein zusätzlicher Schutz für das Wartungspersonal der laufenden Photovoltaikanlage vor Ableitströmen bereitgestellt.

Bei der erfindungsgemäßen Vorrichtung ist neben der Widerstandsmesseinrichtung, die den Isolationswiderstand der Gleichstromseite gegenüber Erde erfasst, eine Strommesseinrichtung vorgesehen, die auf der Gleichstromseite einen Ableitstrom über den Wechselrichter nach Erde erfasst. Da dieser Ableitstrom im Falle eines Erdschlusses auf der Wechselstromseite des Wechselrichters ein schaltfrequenter Wechselstrom, d. h. ein Wechselstrom mit der Schaltfrequenz des Wechselrichters ist, kann die Strommesseinrichtung einen die Leiter der Gleichstromseite umschließenden Ringkern aufweisen, der wie bei einem üblichen FI-Schalter aus kristallinem oder nanokristallinem weichmagnetischen Band gewickelt ist. Die schaltfrequente Magnetisierung des Ringkerns kann entsprechend in herkömmlicher Weise durch eine Induktionsspule erfasst werden.

Die Isolationsmesseinrichtung der neuen Vorrichtung weist vorzugsweise mindestens einen Schalter, mindestens einen einseitig geerdeten Referenzwiderstand und eine Messeinrichtung für den Spannungsabfall über dem Referenzwiderstand auf. Grundsätzlich ist es aber auch möglich, dass die Widerstandsmesseinrichtung eine Spannungsquelle für eine Spannung gegenüber Erde oder auch eine Kostantstromquelle aufweist, um auf eine andere grundsätzlich aus dem Stand der Technik bekannte Art und Weise den Isolationswiderstand der Gleichstromseite des Wechselrichters zu messen, in den bei laufendem Wechselrichter auch der Isolationswiderstand der Wechselstromseite des Wechselrichters eingeht.

Vorteilhafte Weiterbildungen der Erfindung ergeben sich aus den Patentansprüchen, der Beschreibung und den Zeichnungen. Der Schutzbereich ist durch die Patentansprüche definiert.

## KURZBESCHREIBUNG DER FIGUREN

Die Erfindung wird im Folgenden unter Bezugnahme auf die beigefügten Zeichnungen anhand von konkreten Ausführungsbeispielen näher erläutert und beschrieben.

Fig. 1 zeigt ein Schaltbild zu einem IT-Netz mit einem eine Photovoltaikanlage an einen Transformator einschließenden Wechselrichter und einer erfindungsgemäßen Vorrichtung zur Isolationsüberwachung; und

Fig. 2 zeigt eine Alternative zu der Widerstandsmesseinrichtung der Vorrichtung zur Isolationsüberwachung gemäß Fig. 1.

## FIGURENBESCHREIBUNG

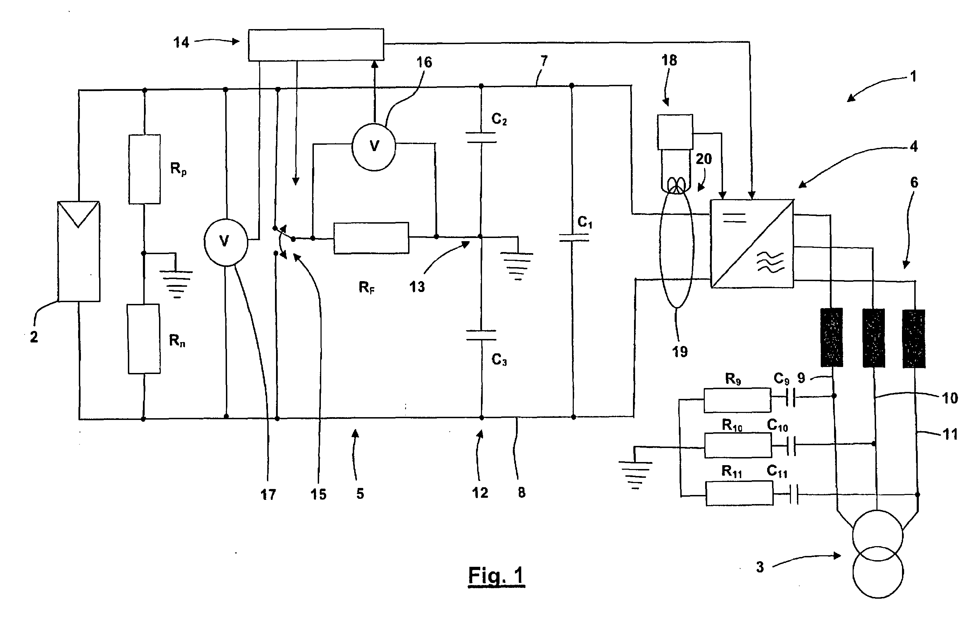

In Fig. 1 ist ein IT-Netz 1, das sich von einer Photovoltaikanlage 2 bis zu einem Transformator 3 erstreckt, mit dem die elektrische Leistung der Photovoltaikanlage 2 in ein geerdetes Wechselstromnetz eingekoppelt wird. Dabei ist ein Wechselrichter 4 vorgesehen, der den von der Photovoltaikanlage 2 kommenden Gleichstrom in einen Wechselstrom umrichtet. Auf diese Weise verbindet der Wechselrichter 4 eine Gleichstromseite 5 des IT-Netzes mit einer Wechselstromseite 6. Diese Verbindung ist hier galvanisch. Das heißt, die Leiter 7 und 8 der Gleichstromseite 5 werden mit den Leitern 9 bis 11 der Wechselstromseite 6 taktweise direkt verbunden, so dass ein galvanischer Kontakt vorliegt. Andere Anforderungen an den Wechselrichter bestehen hier nicht. Er kann daher auf sehr vielfältige konkrete Weise ausgebildet sein. Bei dem ohne Erdung ausgebildeten IT-Netz 1 müssen die Isolationswiderstände $R_p$ des Plusleiters 7 und $R_n$ des Minusleiters 8 auf der Gleichstromseite 5 gegenüber Erde genauso überwacht werden, wie die Isolationswiderstände $R_9$ bis $R_{11}$ gegenüber Erde der Leiter 9 bis 11 auf der Wechselstromseite 6. Dabei sind zusätzlich Isolationskapazitäten $C_9$ bis $C_{11}$ gegenüber Erde auf der Wechselstromseite 6 wirksam. Auch auf der Gleichstromseite 5 spielen Kapazitäten eine Rolle, wobei die dort eingezeichnete Kapazität $C_1$ zugleich die die Kapazität der Photovoltaikanlage 2 und die Kapazität eines etwaigen Pufferkondensators auf der Eingangsseite des Wechselrichters 4 repräsentiert und die Kapazitäten $C_2$ und $C_3$ zugleich für Leitungskapazitäten gegenüber Erde und ein EMV-Filter 12 mit geerdetem Mittelpunkt 13 stehen. Um die Isolationswiderstände zu erfassen, ist eine Widerstandsmesseinrichtung 14 vorgesehen, die mittels eines Umschalters 15 einen Referenzwiderstand $R_F$ der einseitig geerdet ist, wechselweise mit den Leitern 7 und 8 verbindet und dabei mit einem Spannungsmesser 16 eine über dem Widerstand $R_F$ abfallende Spannung $U_{16}$ misst. Zugleich misst die Widerstandsmesseinrichtung 14 mit einem Spannungsmesser 17 die Spannung $U_{17}$ zwischen den Leitern 7 und 8. Aus den Messwerten $U_{16-7}$ und $U_{16-8}$ des Spannungsmessers 16 und $U_{17-7}$ und $U_{17-8}$ des Spannungsmessers 17 bei mit dem Leiter 7 bzw. dem Leiter 8 verbundenem Widerstand $R_F$ ergeben sich die Isolationswiderstände $R_p$ und $R_n$ zu:

$$R_p = R_F((U_{17-7} - U_{16-7})/U_{16-8} - 1)$$

$$R_n = R_F((U_{17-8} - U_{16-8})/U_{16-7} - 1)$$

Bei laufendem Wechselrichter 4 gehen in die Werte von $R_p$ und $R_n$ jeweils auch Anteile von $R_9$ bis $R_{11}$ ein. Gemessen werden können die Werte von $R_p$ und $R_n$

anhand der mit den Spannungsmessern 16 und 17 gemessenen Spannungen jeweils erst nach einigen Sekunden bis Minuten, bis sich die Ladungen über den Kapazitäten $C_1$ bis $C_3$ und $C_9$ bis $C_{11}$ soweit umverteilt haben, dass sie sich in einem Gleichgewichtszustand befinden. Entsprechend werden Änderungen der Isolationswiderstände nur sehr langsam registriert. Sie können aber mit hoher Genauigkeit festgestellt werden. Die Widerstandsmesseinrichtung 14 kann daher auch schleichende und kleine aber unerwünschte Fehler bei den Isolationswiderständen feststellen und den Wechselrichter 4 zur Vermeidung resultierender Schäden abschalten. Das Verhältnis von $R_p$ zu $R_n$ gibt überdies einen Hinweis darauf, wo ein Isolationsfehler auftritt. Ein Isolationsfehler auf der Wechselstromseite 6 beeinträchtigt $R_p$ und $R_n$ gleichermaßen. Ein Isolationsfehler auf der Gleichstromseite 7 führt typischerweise zunächst zu der Verschlechterung nur eines der beiden Isolationswiderstände $R_p$ oder $R_n$.

Eine zusätzliche Strommesseinrichtung 18 misst einen instationären Ableitstrom auf der Gleichstromseite 5, indem die Leiter 7 und 8 durch einen Ringkern 19 geführt sind, um den herum eine Induktionsspule 20 angeordnet ist. Ein Kurzschluss eines der Leiter 9 bis 11 auf der Wechselstromseite 6 macht sich über den Wechselrichter 4 in einem instationären Ableitstrom auf der Gleichstromseite 5 bemerkbar, der zu einer instationären Magnetisierung des Ringkerns 19 und damit einem Signal an der Induktionsspule 20 führt. Dieses Signal kann auf das Überschreiten eines Grenzwerts überwacht werden. Sobald dieser Grenzwert, der für einen maximal zulässigen Ableitstrom steht, erreicht oder überschritten wird, schaltet die Strommesseinrichtung 18 den Wechselrichter 4 ab. Gewisse Ableitströme treten aufgrund der Isolationskapazitäten $C_9$ bis $C_{11}$ immer auf, so dass der Grenzwert für den Ableitstrom nicht auf null gesetzt werden kann. Bei einem Kurzschluss eines der Leiter 8 bis 11 auf der Wechselstromseite 6 gegenüber Erde steigt der Ableitstrom aber schnell stark an. Hieraus resultiert ebenso schnell ein Signal an der Induktionsspule 20, das zum ebenfalls sehr schnellen Abschalten des Wechselrichters 4 verwendet werden kann. Indem der Ringkern 19 die Leiter 7 und 8 in an sich ungewöhnlicher Weise auf der Gleichstromseite 5 umschließt, werden mit der Strommesseinrichtung 18 jegliche Ableitströme stromab dieser Messstelle erfasst und nicht erst ab einem bestimmten Punkt auf der Wechselstromseite 6.

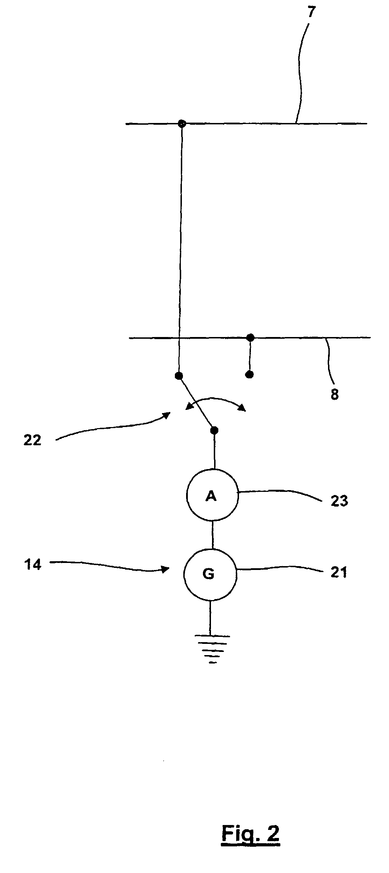

Fig. 2 skizziert eine alternative Ausführungsform der Widerstandsmesseinrichtung 14. Diese umfasst hier eine Gleichspannungsquelle 21 gegenüber Erde, die mit einem Umschalter 22 wechselweise mit den Leitern 7 und 8 verbindbar ist. Dabei wird der gegenüber Erde fließende Strom von einem Strommesser 23 erfasst. Aus der Ausgangsspannung der Gleichspannungsquelle 21 und dem Strom ergibt sich der Isolationswiderstand des jeweiligen Leiters 7 bzw. 8 unmittelbar. Dabei kann zusätzlich die Polarität der Gleichspannungsquelle 21 für zwei Messungen des Isolationswiderstands desselben Leiters umgekehrt werden, um die Messgenauigkeit zu erhöhen. Fig. 2 zeigt nur die für die alternative Ausführungsform der Strommesseinrichtung 14 relevanten Details. Ansonsten kann der gesamte Aufbau Fig. 1 entsprechen.

## **BEZUGSZEICHENLISTE**

| 1 | IT-Netz |
| 2 | Photovoltaikanlage |
| 3 | Transformator |
| 4 | Wechselrichter |
| 5 | Gleichstromseite |
| 6 | Wechselstromseite |
| 7 | Leiter |
| 8 | Leiter |
| 9 | Leiter |
| 10 | Leiter |
| 11 | Leiter |
| 12 | EMV-Filter |
| 13 | Mittelpunkt |
| 14 | Strommesseinrichtung |
| 15 | Umschalter |
| 16 | Spannungsmesser |
| 17 | Spannungsmesser |
| 18 | Strommesseinrichtung |
| 19 | Ringkern |
| 20 | Induktionsspule |
| 21 | Gleichspannungsquelle |
| 22 | Umschalter |
| 23 | Strommesser |

**Patentansprüche**

1. Verfahren zur Isolationsüberwachung eines IT-Netzes (1), d.h. eines Netzes ohne Neutralleiter, gegenüber Erde, mit einem eine Gleichstromseite (5) mit einer Wechselstromseite (6) des IT-Netzes (1) verbindenden Wechselrichter (4) und mit einer Photovoltaikanlage (2) auf der Gleichstromseite (5) des IT-Netzes (1), wobei mindestens ein Isolationswiderstand ($R_p$, $R_n$) der Gleichstromseite (5) gegenüber Erde bei laufendem Wechselrichter (4) auf das Unterschreiten eines Widerstandsgrenzwerts überwacht wird, **dadurch gekennzeichnet, dass** auf der Gleichstromseite (5) zusätzlich ein Ableitstrom über den laufenden Wechselrichter (4) nach Erde auf das Überschreiten eines Stromgrenzwerts überwacht wird.

2. Verfahren zur Isolationsüberwachung nach Anspruch 1, **dadurch gekennzeichnet, dass** instationäre Anteile des Ableitstroms auf das Überschreiten des Stromgrenzwerts überwacht werden.

3. Verfahren zur Isolationsüberwachung nach Anspruch 1 oder 2, **dadurch gekennzeichnet, dass** sowohl bei Unterschreiten des Widerstandgrenzwerts als auch bei Überschreiten des Stromgrenzwerts der Wechselrichter (4) abgeschaltet und/oder eine Warnmeldung ausgegeben wird.

4. Verfahren zur Isolationsüberwachung nach einem der Ansprüche 1 bis 3, **dadurch gekennzeichnet, dass** der Ableitstrom durch Überwachen der Differenz des Stroms durch die beiden Leiter (7, 8) der Gleichstromseite (5) zu dem Wechselrichter (4) überwacht wird.

5. Verfahren zur Isolationsüberwachung nach Anspruch 4, **dadurch gekennzeichnet, dass** die Differenz des Stroms induktiv überwacht wird.

6. Verfahren zur Isolationsüberwachung nach einem der Ansprüche 1 bis 5, **dadurch gekennzeichnet, dass** der Isolationswiderstand durch Vergleich mit Referenzwiderständen ($R_F$) überwacht wird.

7. Verfahren zur Isolationsübenrvachung nach einem der Ansprüche 1 bis 6, **dadurch gekennzeichnet, dass** die Isolationswiderstände ($R_p$, $R_n$) der beiden Leiter (7, 8) der Gleichstromseite (5) nach Erde einzeln überwacht werden.

8. Verfahren zur Isolationsüberwachung nach einem der Ansprüche 1 bis 7, **dadurch gekennzeichnet, dass** zwischen die beiden Leiter (7, 8) der Gleichstromseite (5) zwei Kapazitäten ($C_2$, $C_3$) in Reihe geschaltet sind, deren Mittelpunkt (13) geerdet ist.

9. Vorrichtung zur Isolationsüberwachung eines IT-Netzes (1), d.h. eines Netzes ohne Neutralleiter, gegenüber Erde, das einen eine Gleichstromseite (5) mit einer Wechselstromseite (6) des IT-Netzes (1) galvanisch verbindenden Wechselrichter (4) und eine Photovoltaikanlage (2) auf der Gleichstromseite (5) des IT-Netzes (1) aufweist, mit einer Widerstandsmesseinrichtung (14), die mindestens einen Isolationswiderstand ($R_p$, $R_n$) der Gleichstromseite (5) gegenüber Erde erfasst, mit einem Widerstandsgrenzwert vergleicht und bei Unterschreiten des Widerstandsgrenzwerts ein Signal ausgibt, **dadurch gekennzeichnet, dass** zusätzlich eine Strommesseinrichtung (18) vorgesehen ist, die auf der Gleichstromseite (5) einen Ableitstrom über den Wechselrichter (4) nach Erde erfasst, mit einem Stromgrenzwert vergleicht und bei Überschreiten des Stromgrenzwerts ein Signal ausgibt.

10. Vorrichtung nach Anspruch 9, **dadurch gekennzeichnet, dass** sowohl die Widerstandsmesseinrichtung (14) als auch die Strommesseinrichtung (18) mit ihrem Signal den Wechselrichter (4) ausschaltet und/oder die Ausgabe einer Warnmeldung auslöst.

11. Vorrichtung nach Anspruch 9 oder 10, **dadurch gekennzeichnet, dass** die Strommesseinrichtung (18) den Ableitstrom durch Erfassen der Differenz des Stroms durch die beiden Leiter (7, 8) der Gleichstromseite zu dem Wechselrichter (4) erfasst.

12. Vorrichtung nach Anspruch 11, **dadurch gekennzeichnet, dass** die Strommesseinrichtung (18) einen die Leiter (7, 8) der Gleichstromseite (5) umschließenden Ringkern (19) aufweist.

13. Vorrichtung nach einem der Ansprüche 9 bis 12, **dadurch gekennzeichnet, dass** die Widerstandsmesseinrichtung (14) mindestens einen Schalter (15), mindestens einen einseitig geerdeten Referenzwiderstand ($R_F$) und eine Messeinrichtung (16) für den Spannungsabfall über dem Referenzwiderstand ($R_F$) aufweist.

14. Vorrichtung nach Anspruch 13, **dadurch gekennzeichnet, dass** die Widerstandsmesseinrichtung (14) die beiden Leiter (7, 8) der Gleichstromseite (5) einzeln mit dem Referenzwiderstand ($R_F$) verbindet.

15. Vorrichtung nach einem der Ansprüche 9 bis 14, **dadurch gekennzeichnet, dass** zwischen die beiden Leiter (7, 8) der Gleichstromseite (5) zwei Kapazitäten ($C_2$, $C_3$) eines EMV-Filters (12) in Reihe geschaltet sind, dessen Mittelpunkt (13) geerdet ist.

**Claims**

1. Method of isolation monitoring of an IT network, i. e. of a network without neutral conductor, with regard to earth, comprising an inverter (4) connecting a DC side (5) with an AC side (6) of the IT network (1), and a photovoltaic generator (2) on the DC side (5) of the IT network (1), wherein at least one isolation resistance ($R_p$, $R_n$) of the DC-side (5) with regard to earth is monitored with regard to falling below a resistance threshold value while the inverter (4) is running, **characterized in that** additionally an earth leakage current over the running inverter (4) is monitored on the DC-side (5) with regard to exceeding a current threshold value.

2. Method of isolation monitoring according to claim 1, **characterized in that** non-stationary parts of the leakage current are monitored with regard to exceeding the current threshold value.

3. Method for isolation monitoring according to claim 1 or 2, **characterized in that** both upon falling below the resistance threshold value and upon exceeding the current threshold value the inverter (4) is switched off and/or a warning message is issued.

4. Method for isolation monitoring according to any of the claims 1 to 3, **characterized in that** the leakage current is monitored by monitoring the difference of the currents to the inverter (4) through both conductors (7, 8) of the DC side (5).

5. Method for isolation monitoring according to claim 4, **characterized in that** the difference of the currents is inductively monitored.

6. Method for isolation monitoring according to any of the claims 1 to 5, **characterized in that** the isolation resistance is monitored by comparison with reference resistances ($R_F$).

7. Method for isolation monitoring according to any of the claims 1 to 6, **characterized in that** the isolation resistances ($R_p$, $R_n$) of both conductors (7, 8) of the DC side (5) with regard to earth are separately monitored.

8. Method for isolation monitoring according to any of the claims 1 to 7, **characterized in that** two capacities ($C_2$, $C_3$) are connected in series between the two conductors (7, 8) of the DC side (5), a centre point of the two capacities ($C_2$, $C_3$) being connected to earth.

9. Device for isolation monitoring of an IT network, i. e. of a network without neutral conductor, with regard to earth, which comprises an inverter (4) galvanically connecting a DC side (5) with an AC side (6) of the IT network (1), and a photovoltaic generator (22) on the DC side (5) of the IT network (1), the device comprising a resistance measuring unit (14) which measures at least one isolation resistance ($R_p$, $R_n$) of the DC side (5) with regard to earth, compares the at least one isolation resistance (($R_p$, $R_n$) with a resistance threshold value and issues a signal upon falling below the resistance threshold value, **characterized in that** additionally a current measuring unit (18) is provided which measures an earth leakage current over the inverter (4) on the DC side (5), compares the leakage current with a current threshold value and issues a signal upon exceeding the current threshold value.

10. Device according to claim 9, **characterized in that** both the resistance measuring unit (14) and the current measuring unit (18) switch off the inverter (4) and/or trigger the output of a warning message with their signal.

11. Device according to claim 9 or 10, **characterized in that** the current measuring unit (18) measures the leakage current by measuring the difference of the currents to the inverter (4) through the two conductors (7, 8) of the DC side.

12. Device according to claim 11, **characterized in that** the current measuring device (18) comprises a ring core (19) enclosing the conductors (7, 8) of the DC side (5).

13. Device according to any of the claims 9 to 12, **characterized in that** the resistance measuring unit (14) comprises at least one switch (15), at least one single-side grounded reference resistance ($R_F$) and a measuring unit (16) for the voltage drop over the reference resistance ($R_F$).

14. Device according to claim 13, **characterized in that** the resistance measuring unit (14) separately connects the two conductors (7, 8) of the DC side (5) to the reference resistance ($R_F$).

15. Device according to any of the claims 9 to 14, **characterized in that**, between the two conductors (7, 8) of the DC side (5), two capacities ($C_2$, $C_3$) of an EMC-filter (12) are connected in series, the centre point (13) of the two capacities ($C_2$, $C_3$) being connected to earth.

**Revendications**

1. Procédé de contrôle de l'isolement par rapport à la terre d'un réseau isolé de la terre (1), c'est-à-dire d'un réseau sans conducteur neutre, comportant un onduleur (4), qui relie un côté à courant continu (5) à un côté à courant alternatif (6) du réseau isolé de la terre (1), et comportant une installation photovoltaïque (2) sur le côté à courant continu (5) du réseau isolé de la terre (1), sachant qu'au moins une résistance d'isolement ($R_p$, $R_n$) du côté à courant continu (5) est contrôlée par rapport à la terre pour détecter si, en cours de service de l'onduleur (4), la valeur de la résistance est inférieure à une valeur limite de la résistance, **caractérisé en ce que** sur le côté à courant continu (5), de surcroît, un courant de fuite vers la terre via l'onduleur (4) en marche est contrôlé pour détecter si la valeur du courant est supérieure à une valeur limite du courant.

2. Procédé de contrôle de l'isolement selon la revendication 1, **caractérisé en ce que** des parts turbulentes du courant de fuite sont contrôlées pour détecter si la valeur du courant est supérieure à la valeur limite du courant.

3. Procédé de contrôle de l'isolement selon la revendication 1 ou 2, **caractérisé en ce que** tant dans le cas d'un dépassement de la limite inférieure de la valeur limite de la résistance que dans le cas d'un dépassement de la limite supérieure d'une valeur limite du courant, l'onduleur (4) est débranché et/ou un message d'alarme est délivré.

4. Procédé de contrôle de l'isolement selon l'une quelconque des revendications 1 à 3, **caractérisé en ce que** le courant de fuite est contrôlé par l'intermédiaire du contrôle de la différence du courant à travers les deux conducteurs (7, 8) du côté à courant continu (5) vers l'onduleur (4).

5. Procédé de contrôle de l'isolement selon la revendication 4, **caractérisé en ce que** la différence du courant est contrôlée par voie inductive.

6. Procédé de contrôle de l'isolement selon l'une quelconque des revendications 1 à 5, **caractérisé en ce que** la résistance d'isolement est contrôlée par la comparaison avec des résistances de référence ($R_F$).

7. Procédé de contrôle de l'isolement selon l'une quelconque des revendications 1 à 6, **caractérisé en ce que** les résistances d'isolement ($R_p$, $R_n$) des deux conducteurs (7, 8) du côté à courant continu (5) vers la terre sont contrôlées séparément.

8. Procédé de contrôle de l'isolement selon l'une quelconque des revendications 1 à 7, **caractérisé en ce que** deux capacités (C2, C3), dont le centre (13) est relié à la terre, sont montées en série entre les deux conducteurs (7, 8) du côté à courant continu (5).

9. Dispositif de contrôle de l'isolement par rapport à la terre d'un réseau isolé de la terre (1), c'est-à-dire d'un réseau sans conducteur neutre, qui comporte un onduleur (4), qui établit une liaison galvanique entre un côté à courant continu (5) et un côté à courant alternatif (6) du réseau isolé de la terre (1), et une installation photovoltaïque (2) sur le côté à courant continu (5) du réseau isolé de la terre (1), avec un dispositif de mesure de la résistance (14), qui détecte au moins une résistance d'isolement ($R_p$, $R_n$) du côté à courant continu (5) par rapport à la terre, la compare à une valeur limite de la résistance et délivre un signal en cas de dépassement de la limite inférieure de la valeur limite de résistance, **caractérisé en ce qu'**il est prévu, de surcroît, un dispositif de mesure du courant (18), qui détecte sur le côté à courant continu (5) un courant de fuite via l'onduleur (4) vers la terre, le compare à une valeur limite de courant et délivre un signal en cas de dépassement de la limite supérieure de la valeur limite du courant.

10. Dispositif selon la revendication 9, **caractérisé en ce que** tant le dispositif de mesure de la résistance (14) que le dispositif de mesure du courant (18) déconnectent par leur signal l'onduleur (4) et/ou déclenchent l'émission d'un message d'alarme.

11. Dispositif selon la revendication 9 ou 10, **caractérisé en ce que** le dispositif de mesure du courant (18) détecte le courant de fuite par la détection de la différence du courant à travers les deux conducteurs (7, 8) du côté à courant continu vers l'onduleur (4).

12. Dispositif selon la revendication 11, **caractérisé en ce que** le dispositif de mesure du courant (18) comporte un noyau annulaire (19) entourant les conducteurs (7, 8) du côté à courant continu (5).

13. Dispositif selon l'une quelconque des revendications 9 à 12, **caractérisé en ce que** le dispositif de mesure de la résistance (14) comporte au moins un commutateur (15), au moins une résistance de référence ($R_F$) reliée d'un côté à la terre, et un dispositif de mesure (16) pour la chute de tension via la résistance de référence ($R_F$).

14. Dispositif selon la revendication 13, **caractérisé en ce que** le dispositif de mesure de la résistance (14) relie les deux conducteurs (7, 8) du côté à courant continu (5) séparément avec la résistance de référence ($R_F$).

15. Dispositif selon l'une quelconque des revendications 9 à 14, **caractérisé en ce que** deux capacités (C2, C3) d'un filtre CEM (12), dont le centre (13) est relié à la terre, sont montées en série entre les deux conducteurs (7, 8) du côté à courant continu (5).

Fig. 1

7

8

22

A    23

14    G    21

**Fig. 2**

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102006022686 A1
- EP 1265076 B1
- EP 0833423 A2
- US 20020105765 A1